# EUROPÄISCHE PATENTANMELDUNG

(11) **EP 0 416 323 A2**
(43) Veröffentlichungstag der Anmeldung: **13.03.1991**
(21) Anmeldenummer: 90115418.7
(22) Anmeldetag: 10.08.1990
(51) Int. Cl.: H03K 19/0175, G05F 3/24, H03K 19/086

(54) **Signalpegelwandler**

(30) Priorität: 04.09.1989 DE 3929351
(71) Anmelder: SIEMENS AKTIENGESELLSCHAFT, D-80333 München (DE)
(72) Erfinder: Barré, Claude, Dipl.-Ing., D-8000 München 70 (DE)

(57) **Zusammenfassung**

Ein Signalpegelwandler zur Umsetzung von digitalen Eingangssignalpegeln mit relativ großem Eingangssignalpegelhub auf CML- bzw. ECL-Ausgangssignalpegel besteht aus einem Stromquellenfeldeffekttransistor (Q) zur Bildung einer Konstantstromquelle, einem im ausgangsseitigen Strompfad der Konstantstromquelle angeordneten Arbeitswiderstand (R) und einem im Strompfad vor oder hinter der Konstantstromquelle angeordneten Schaltelement aus wenigstens einem Steuerungsfeldeffekttransistor (S). Durch die Kombination einer Konstantstromquelle und eines Schaltelementes wird die Funktion zur Einstellung eines Ausgangssignalpegelhubes von der Schaltfunktion getrennt. Der Wert des Ausgangssignalpegelhubes läßt sich unabhängig von Prozeßstreuungen und Temperaturschwankungen mit Hilfe eines kompensierenden Referenzspannungsgenerators für die Konstantstromquelle äußerst exakt einstellen und einhalten.

## Beschreibung

Die Erfindung betrifft einen Signalpegelwandler zur Umsetzung von digitalen Eingangssignalpegeln auf CML- bzw. ECL-Eingangssignalpegel bei einem gegenüber einem Ausgangssignalpegelhub größeren Eingangssignalpegelhub.

Derartige Signalpegelwandler sind z.B. CMOS-CML/ECL-Wandler, die den von einem CMOS-Eingangssignalpegel repräsentierten binären Wert nach CMOS-Maßgaben identifizieren und einen entsprechenden, nach CML- bzw. ECL-Maßgaben zur Repräsentation dieses binären Wertes vorgesehenen Ausgangssignalpegel erzeugen. Mitunter invertieren Signalpegelwandler den identifizierten binären Wert und führen damit zusätzlich zur Pegelwandlung noch eine logische Inverterfunktion aus.

Gegenüber den Signalpegeln der CMOS-Logik, bei denen die Spannungswerte für die digitalen L- und H-Pegel den Werten der Versorgungsspannungspotentiale entsprechen, liegt bei der Stromschalterlogik (CML) der digitale H-Pegel beim positiveren Wert der beiden Versorgungsspannungspotentiale und der digitale L-Pegel bei einem nur ca. 0,5 Volt negativeren Wert. Im Falle der Emitter-gekoppelten Logik (ECL) liegt der digitale H-Pegel ca. 0,9 Volt und der digitale L-Pegel ca. 1,7 Volt negativer als der positivere Wert der beiden Versorgungsspannungspotentiale.

Geht man von einer Versorgungsspannungspotentialdifferenz von ca. 5 Volt aus, so muß ein CMOS-CML/ECL-Wandler demnach einen Signalpegelhub von 5 Volt auf einen Signalpegelhub von 0,5 Volt für CML bzw. 0,8 Volt für ECL - unter Berücksichtigung jeweiliger Störabstände- umsetzen.

Ein bekannter CMOS-CML/ECL-Wandler besteht aus einem Feldeffekttransistor in Sourceschaltung, der mit seiner Source-Elektrode an das negativere und mit seiner Drain-Elektrode über einen Arbeitswiderstand an das positivere der beiden Versorgungsspannungspotentiale angeschlossen ist. Zum Arbeitswiderstand ist eine in Flußrichtung gepolte Diode parallelgeschaltet.

Mit dieser Diode kann der Signalpegelhub am Arbeitswiderstand und damit am Wandlerausgang auf einen durch die Flußspannung der Diode vorgegebenen Wert, der allerdings bei etwa 0,8 Volt für Siliziumdioden liegt, begrenzt werden.

Der genaue Wert der Flußspannung einer solchen Diode, mit deren Hilfe sich der Spannungswert für den digitalen L-Pegel am Wandlerausgang begrenzen läßt, ist jedoch von verschiedenen Bedingungen beim Fertigungsprozeß der Diode abhängig. Außerdem ist der Wert der Flußspannung einer Diode bekanntlich temperaturabhängig.

Aus diesen Gründen können die Zielvorgaben bei der Realisierung eines bekannten CMOS-CML/ECL-Wandlers nur ungefähr erreicht werden. Außerdem wird der Betriebstemperaturbereich einer mit dem bekannten CMOS-CML/ECL-Wandler versehenen integrierten Schaltung durch die Temperaturempfindlichkeit des Signalpegelwandlers eingeschränkt.

Aufgabe der vorliegenden Erfindung ist es daher einen integrierbaren Signalpegelwandler zur Umsetzung von digitalen Eingangssignalpegeln auf CML-bzw. ECL-Signalpegel bei einem gegenüber dem Ausgangssignalpegelhub größeren Eingangssignalpegelhub anzugeben, bei dem sich der Ausgangssignalpegelhub am Wandlerausgang unabhängig von Fertigungstoleranzen sowie Temperatur- und Versorgungspannungsschwankungen präzise festlegen läßt.

Gelöst wird die Aufgabe erfindungsgemäß durch die im Patentanspruch 1 angegebenen Merkmale.

Bei dem erfindungsgemäß ausgebildeten Signalpegelwandler wird der Signalpegelhub am Wandlerausgang ausschließlich durch den Strom aus einer Konstantstromquelle eingestellt. Der wesentliche Vorteil besteht darin, daß sich eine Konstantstromquelle auf einfache Weise durch eine Referenzspannung kontrollieren läßt, die ihrerseits von einem Referenzspannungsgenerator gebildet werden kann, der mit Schaltungsmaßnahmen zur Kompensation von Prozeßstreuungen und Temperaturschwankungen versehen ist.

Ein solcher Referenzspannungsgenerator ist jedoch nicht Gegenstand der vorliegenden Erfindung.

Ein weiterer Vorteil des erfindungsgemäß ausgebildeten Signalpegelwandlers besteht darin, daß durch die strikte Trennung von Schaltfunktion und Pegeleinstellung durch ein Schaltelement bzw. eine Konstantstromquelle eine im Schaltpunkt steilere und damit günstigere Übertragungskennlinie des Signalpegelwandlers erzielt werden kann.

Vorteilhafte Ausgestaltungen und Weiterbildungen der Erfindung sind in den Ansprüchen 2 bis 8 angegeben.

Eine besonders vorteilhafte Verwendung des erfindungsgemäß ausgebildeten Signalpegelwandlers sowie eine zugehörige vorteilhafte Schaltungsanordnung ist in den Ansprüchen 9 bzw. 10 angegeben.

Mehrere Ausführungsbeispiele der Erfindung werden im folgenden anhand der Zeichnung näher erläutert.
Dabei zeigen
FIG 1 ein Schaltbild für einen bekannten Signalpegelwandler,
FIG 2 eine Übertragungskennlinie des bekannten Signalpegelwandlers,
FIG 3 ein Schaltbild für einen erfindungsgemäß ausgebildeten Signalpegelwandler,
FIG 4 ein Schaltbild für einen erfindungsgemäß ausgebildeten Signalpegelwandler mit einer logischen Verknüpfung mehrerer Wandlereingänge,
FIG 5 zwei Schaltbilder eines erfindungsgemäß ausgebildeten Signalpegelwandlers mit einer Stromspiegelschaltung zur Erzielung eines weiteren Wandlerausganges,
FIG 6 ein Schaltbild für eine CML/ECL-Schaltstufe, bei der der erfindungsgemäß ausgebildete Signalpegelwandler als abschaltbare Konstantstromquelle dient.

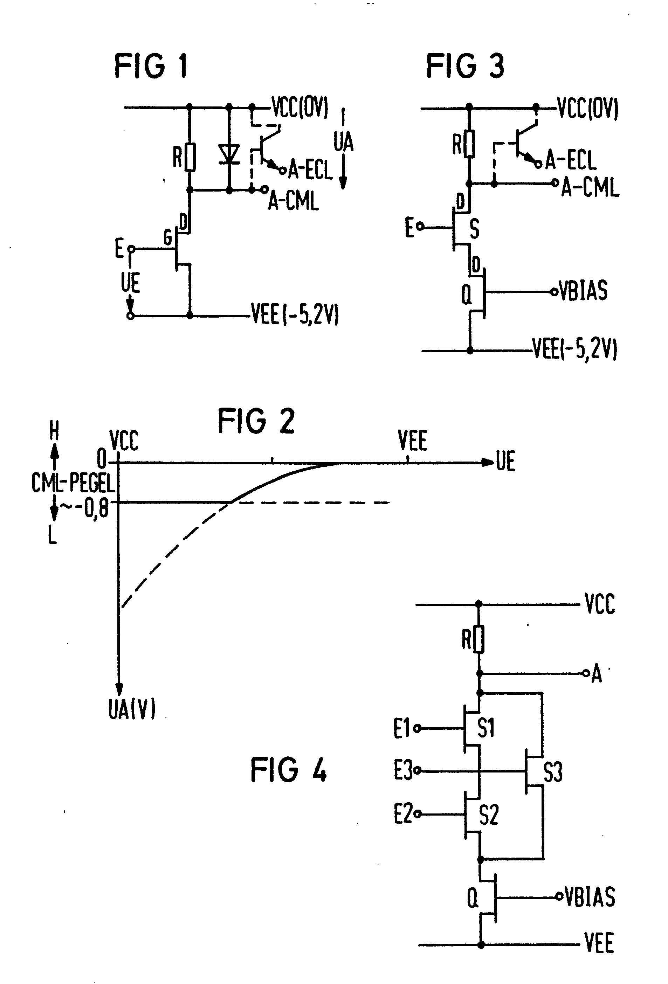

In der FIG 1 ist ein Schaltbild eines bekannten CMOS-CML/ECL-Wandlers dargestellt, der aus einem einzigen, in Source-Schaltung betriebenen Feldeffekttransistor besteht, zu dessen Arbeitswiderstand eine Diode in Durchlaßrichtung parallelgeschaltet ist.

Der als N-MOS-Typ ausgebildete Feldeffekttransistor ist an seiner Sourceelektrode S mit einem Versorgungsspannungspotential VEE und an seiner Drainelektrode D über den Arbeitswiderstand R mit einem, gegenüber dem Versorgungsspannungspotential VEE positiveren weiteren Versorgungsspannungspotential VCC verbunden. Die Spannungsdifferenz zwischen den beiden Versorgungsspannungspotentialen VEE, VCC beträgt etwa 5,2 Volt und kann damit sowohl für CMOS-Schaltungen als auch für CML- bzw. ECL-Schaltungen verwendet werden. Als 0 Volt oder Massepotential ist allerdings in der CMOS-Logik das negativere Versorgungsspannungspotential VEE und in der CML- bzw. ECL-Logik das positivere weitere Versorgungsspannungspotential VCC vorgesehen.

Als Wandlereingang E für CMOS-Signalpegel dient die Gateelektrode G und als Wandlerausgang A-CML für CML-Signalpegel die Drainelektrode D des Feldeffekttransistors. Zur Bildung eines Wandlerausgangs A-ECL für ECL-Signalpegel ist ein NPN-Transistor mit seiner Basis-Kollektorstrecke dem Arbeitswiderstand R parallelgeschaltet, wobei die Emitterelektrode des NPN-Transistors als Wandlerausgang A-ECL dient.

Die in Durchlaßrichtung gepolte Diode erlaubt am Arbeitswiderstand einen maximalen Spannungsabfall in Höhe ihrer Flußspannung, wodurch am Wandlerausgang A-CML nur ein Signalhub von etwa 0,8 Volt auftreten kann.

In der FIG 2 ist eine Übertragungskennlinie für den bekannten Signalpegelwandler nach FIG 1 dargestellt, aus der die Begrenzung der Signalpegelspannung am Wandlerausgang A durch die Flußspannung der Diode ersichtlich ist.

In der FIG 3 ist ein Schaltbild eines als CMOS-CML/ECL-Wandler dienenden erfindungsgemäß ausgebildeten Signalpegelwandlers mit einem Stromquellenfeldeffekttransistor Q, im folgenden abgekürzt Stromquellen-FET Q, und einem in Serie geschalteten Steuerungsfeldeffekttransistor 5, im folgenden abgekürzt Steuerungs-FET S, dargestellt. Der Stromquellen-FET Q und der Steuerungs-FET S bilden mit ihren Drain-Source-Strecken und einem Arbeitswiderstand R eine Serienschaltung, wobei im gezeigten Ausführungsbeispiel die Drain-Source-Strecke des Stromquellen-FET's Q an das Versorgungsspannungspotential VEE (z.B. -5,2 Volt) und die Drain-Source-Strecke des Steuerungs-FET's S über den Arbeitswiderstand R an das gegenüber dem Versorgungsspannungspotential VEE positivere weitere Versorgungsspannungspotential VCC (0 Volt) angeschlossen ist.

In manchen Anwendungsfällen wäre es auch denkbar, daß die beiden Feldeffekttransistoren in ihrer Reihenfolge vertauscht sind und der Stromquellen-FET Q mit seiner Source-Strecke zwischen dem Arbeitswiderstand R und dem Steuerungs-FET S angeordnet ist. Jedoch ist die Schaltgeschwindigkeit des Signalpegelwandlers höher, wenn der Steuerungs-FET S an den Arbeitswiderstand R angeschlossen ist. Eine konstantere Einhaltung des Spannungswertes für den digitalen L-Pegel erhält man, wenn die Sourceelektrode des Stromquellen Fets Q vom Steuerungs Fet S abgewandt ist.

Sowohl der Stromquellen- wie auch der Steuerungs-FET Q, S, sind im vorliegenden Ausführungsbeispiel als symmetrische NMOS-Feldeffekttransistor ausgebildet, obwohl natürlich nichts dagegen spricht, einen der beiden oder beide als PMOS-Feldeffekttransistoren auszubilden.

Wird der Steuerungs-FET S aber als NMOS-Feldeffekttransistor ausgeführt, so kann durch Dimensionierung des Steuerungs-FETs S der Schwellpunkt des erfindungsgemäß ausgebildeten Signalpegelwandlers so verschoben werden, daß er als TTL-CML/ECL-Signalpegelwandler verwendet werden kann. Dem folgenden wird aber weiterhin ein CMOS-CML/ECL-Wandler zugrundegelegt.

Der Stromquellen-FET Q wird an seiner Gateelektrode von einer Referenzspannung VBIAS beaufschlagt und bildet dadurch eine Konstantstromquelle. Die Gateelektrode des Steuerungs-Fets S dient als Wandlereingang E für CMOS-Signalpegel.

An dem, dem weiteren Versorgungsspannungspotential VCC gegenüberliegenden Anschluß des Arbeitswiderstandes R ist ein Abgriff vorgesehen, der den Wandlerausgang A-CML für CML-Signalpegel bildet. Zur Bildung von ECL-Signalpegeln kann, wie beim bekannten Signalpegelwandler, ein NPN-Transistor mit seiner Kollektor-Basis-Strecke dem Arbeitswiderstand R parallelgeschaltet sein. Die Emitterelektrode dieses NPN-Transistors dient dann als Wandlerausgang A-ECL für ECL-Signalpegel.

Eine solche Umformung von CML-Signalpegeln auf ECL-Signalpegel mit Hilfe eines Bipolartransistors ist stets möglich, weshalb im folgenden zur Vereinfachung nur noch auf den Wandlerausgang A-CML (im folgenden Wandlerausgang A genannt), eingegangen wird.

Bei einem digitalen CMOS-H-Pegel am Wandlereingang E, der mit seinem Spannungswert etwa dem Wert des weiteren Versorgungsspannungspotentials VCC (0 Volt) entspricht, ist der Steuerungs-FET S und damit der Strompfad über den Arbeitswiderstand R geschlossen. Der Strom durch den Arbeitswiderstand R und damit der Spannungsabfall über dem Arbeitswiderstand R, der am Wandlerausgang A einen digitalen CML-L-Pegel erzeugt, wird ausschließlich durch die Referenzspannung VBIAS am Stromquellen-FET bestimmt.

Bei einem digitalen CMOS-L-Pegel am Wandlereingang E, der einen in etwa dem Wert des Versorgungsspannungspotentials VEE (-5,2 Volt) entsprechenden Spannungswert aufweist, ist der Steuerungs-FET S offen, d.h. er bildet einen sehr großen Widerstand. Durch den Arbeitswiderstand R fließt kein nennenswerter Strom. Der Wandlerausgang A liegt deshalb auf dem Spannungswert des weiteren Versorgungsspannungspotentials VCC (0 Volt), der einem digitalen CML-H-Pegel entspricht.

In der FIG 4 ist ein Schaltbild für einen als CMOS-CML/ECL-Wandler dienenden, erfindungsgemäß ausgebildeten Signalpegelwandler mit einem aus drei Steuerungs-FET's S1, S2, S3 gebildeten Schaltelement dargestellt. Dieser Signalpegelwandler unterscheidet sich von dem Signalpegelwandler nach FIG 3 lediglich dadurch, daß der Steuerungs-FET S in FIG 3 durch drei Steuerungs-FET's S1, S2, S3 zur Bildung von Logik ersetzt ist.

Ein erster und ein zweiter Steuerungs-FET S1, S2, bilden mit ihren Drain-Source-Strecken eine Reihenschaltung, zu der ein dritter Steuerungs-FET S3 mit seiner Drain-Source-Strecke parallelgeschaltet ist. Der Stromquellen-FET Q bzw. der Arbeitswiderstand R verbinden diese Reihenschaltung mit dem Versorgungsspannungspotential VEE bzw. dem weiteren Versorgungsspannungspotential VCC.

Die drei Steuerungs-FET's S1, S2, S3 bilden mit ihren Gateelektroden jeweils einen Wandlereingang E1, E2, E3. Die Reihenschaltung des ersten und des zweiten Steuerungs-FET's S1, S2, bildet eine logische UND-Verknüpfung, da ein Strompfad durch den ersten und den zweiten Steuerungs-FET S1, S2, nur dann zustande kommt, wenn die Wandlereingänge E1 und E2 mit einem digitalen CMOS-H-Pegel (VCC) beaufschlagt werden. Über den dritten Steuerungs-FET S3 kann die Serienschaltung aus dem ersten und zweiten Steuerungs-FET S1, S2 überbrückt werden, was einer logischen ODER-Verknüpfung gleichkommt. Demnach ist am Wandlerausgang A nur dann ein digitaler CML-L-Pegel zu erwarten, wenn entweder die Wandlereingänge E1 und E2 oder aber der Wandlereingang E3 auf einem digitalen CMOS-H-Pegel liegen.

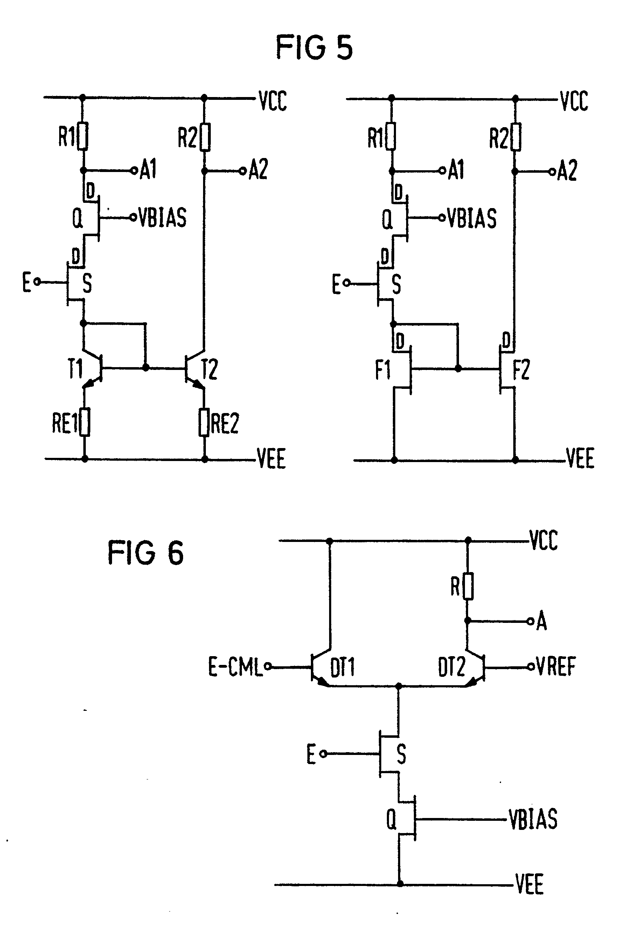

In der FIG 5 sind zwei Schaltbilder für einen als CMOS-CML/ECL-Wandler dienenden, erfindungsgemäß ausgebildeten Signalpegelwandler mit jeweils einer Stromspiegelschaltung zur Erzeugung eines weiteren Wandlerausganges dargestellt.

Die beiden Schaltbilder für erfindungsgemäß ausgebildete Signalpegelwandler unterscheiden sich nur dadurch, daß die Stromspiegelschaltung des im linken Schaltbildes dargestellten Ausführungsbeispieles aus zwei Bipolartransistoren mit zugehörigen Emitterwiderständen und beim im rechten Schaltbild dargestellten Ausführungsbeispiel aus zwei N-MOS-Feldeffekttransistoren gebildet ist.

Bei dem erfindungsgemäß ausgebildeten Signalpegelwandler nach dem linken Schaltbild ist die Reihenschaltung der Drain-Source-Strecken eines Stromquellen FETs Q und eines Steuerungs-FETs S an einem Ende (entspricht bei dem im linken Schaltbild als NMOS-FET ausgebildeten Stromquellen FET Q der Drainelektrode D) über einen Arbeitswiderstand R1 mit dem weiteren Versorgungsspannungspotential VCC und am gegenüberliegenden Ende über die Kollektor-Emitter-Strecke eines, der Stromspiegelschaltung zugehörigen ersten NPN-Transistors T1 und dessen Emitterwiderstand RE1 mit dem Versorgungsspannungspotential VEE verbunden. Ein zweiter, der Stromspiegelschaltung zugehöriger NPN-Transistor T2, der mit dem ersten NPN-Transistor T1 Basis-gekoppelt ist, ist mit seiner Kollektorelektrode über einen weiteren Arbeitswiderstand R2 mit dem weiteren Versorgungsspannungspotential VCC und mit seiner Emitterelektrode über einen zugehörigen Emitterwiderstand RE2 an das Versorgungsspannungspotential VEE angeschlossen. Am ersten NPN-Transistor T1 sind die Kollektorelektrode und die Basiselektrode miteinander verbunden. Der, dem weiteren Versorgungsspannungspotential VCC gegenüberliegende Anschluß des Arbeitswiderstandes R1 bildet den Wandlerausgang A1, und der dem weiteren Versorgungsspannungspotential VCC gegenüberliegende Anschluß des weiteren Arbeitswiderstandes R2 bildet einen weiteren Wandlerausgang A2.

Bei dem erfindungsgemäß ausgebildeten Signalpegelwandler nach dem rechten Schaltbild der FIG 5 sind die Bipolartransistoren (NPN-Transistoren T1, T2) samt ihrer Emitterwiderstände RE1, RE2 durch zwei NMOS-Feldeffekttransistoren F1, F2 ersetzt. So ist die Reihenschaltung der Drain-Source-Strecken des Stromquellen- und des Steuerungs-FETs Q, S an ihren, dem Arbeitswiderstand R1 gegenüberliegenden Ende über die Drain-Source-Strecke eines esten Feldeffekttransistors F1 an das Versorgungsspannungspotential VEE angeschlossen. Ein zweiter Feldef fekttransistor F2, der mit dem ersten Feldeffekttransistor F1 Gate-gekoppelt ist, ist mit seiner Drainelektrode D über einen weiteren Arbeitswiderstand R2 an das weitere Versorgungsspannungspotential VCC, und mit seiner Sourceelektrode an das Versorgungsspannungspotential VEE angeschlossen. Außerdem ist beim ersten Feldeffekttransistor F1 die Gateelektrode mit der Drainelektrode D verbunden. Der Wandlerausgang A1 und der weitere Wandlerausgang A2 werden durch den, dem weiteren Versorgungsspannungspotential VCC gegenüberliegenden Anschluß des Arbeitswiderstandes R1 bzw. des weiteren Arbeitswiderstandes R2 gebildet.

Die Stromspiegelschaltung, sei sie mit Bipolartransistoren oder mit Feldeffekttransistoren ausgebildet, überträgt den durch die Reihenschaltung aus Stromquellen- und Steuerungs-FET Q, S fließenden Strom und damit den durch den Eingangsstromast der Stromspiegelschaltung fließenden Strom auf ihren Ausgangsstromast. Der Eingangsstromast wird durch den ersten und der Ausgangsstromast durch den zweiten NPN-Transistor T1, T2 bzw. Feldeffekttransistor F1, F2 gebildet. Damit hat der durch den Arbeitswiderstand R1 fließende Strom die gleiche Stärke wie der durch den weiteren Arbeitswiderstand R2 fließende Strom, womit unter der Voraussetzung, daß die beiden Arbeitswiderstände R1, R2 gleiche Werte aufweisen, die Spannungswerte an beiden Wandlerausgängen A1, A2 stets gleich sind.

Die beiden Wandlerausgänge A1, A2 stellen damit voneinander lastunabhängige Ausgangssignalpegel zur Verfügung. Außerdem sind die beiden Ausgangssignale auf den Wandlerausgängen A1, A2 voneinander störungsunabhängig, wodurch sich nachfolgende Schaltungseingänge im Störungsfalle gegenseitig nicht beeinflussen können.

Im Bedarfsfall kann eine Stromspiegelschaltung natürlich mit mehreren Ausgangsstromästen versehen werden.

In der FIG 6 ist ein Schaltbild für eine CML- bzw. ECL-Schaltstufe dargestellt, bei der die ansonsten üblicherweise aus Bipolartransistoren gebildete Konstantstromquelle durch eine erfindungsgemäße Reihenschaltung eines Steuerungs- und eines Stromquellen-FETs S, Q ersetzt ist.

Die CML- bzw. ECL-Schaltstufe besteht im wesentlichen aus einem als Stromschalter ausgebildeten Differenzverstärker mit zwei Emitter-gekoppelten NPN-Transistoren DT1, DT2. Der erste NPN-Transistor DT1 bildet mit seiner Basiselektrode einen Schaltstufeneingang E-CML für CML-Signalpegel. Mit seiner Kollektorelektrode ist dieser NPN-Transistor DT1 an das weitere Versorgungsspannungspotential VCC angeschlossen. Der zweite NPN-Transistor DT2 ist min seiner Kollektorelektrode über einen Arbeitswiderstand R mit dem weiteren Versorgungsspannungspotential VCC verbunden. Die Kollektorelektrode dieses NPN-Transistors DT2 dient auch als Wandlerausgang A für CML-Signalpegel. Die Basiselektrode des zweiten NPN-Transistors DT2 ist mit einer Schaltschwellenreferenzspannung VREF beaufschlagt, die in etwa einen Wert aufweist, der in der Mitte zwischen den Spannungswerten für den digitalen L- und H-CML-Pegel liegt.

Die beiden miteinander verbundenen Emitterelektroden der beiden NPN-Transistoren DT1, DT2 sind über eine Reihenschaltung der Drain-Source-Strecken eines Steuerungs- und eines Stromquellen-FETs S, Q mit dem Versorgungsspannungspotential VEE verbunden. Der Steuerungs-FET S bildet mit seiner Gateelektrode einen Wandlereingang E für CMOS-Signalpegel und an der Gateelektrode des Stromquellen FETs Q, der als NMOS-Feldeffekttransistor ausgebildet ist, liegt eine Referenzspannung VBIAS zur Einstellung eines Konstantstromes für den Differenzverstärker.

Auch in diesem Ausführungsbeispiel nach FIG 6 können, ebenso wie im Ausführungsbeispiel nach FIG 5, der Stromquellen FET Q und der Steuerungs-FET S in ihrer Reihenfolge untereinander vertauscht sein.

Denkbar wäre auch, den Steuerungs-FET durch mehrere serielle oder parallele Steuerungs-FETS zur Bildung von Logik zu ersetzen. Abgesehen davon beinhaltet der erfindungsgemäß ausgebildete Signalpegelwandler nach FIG 6 bereits eine logische Verknüpfung. So kann sich am Wandlerausgang A nur dann ein digitaler CML-L-Pegel einstellen, wenn der Wandlereingang E am Steuerungs-FET S einen digitalen CMOS-H-Pegel, und der CML-Wandlereingang E-CML einen digitalen CML-L-Pegel, also ungefähr -0,5 Volt aufweist.

Andererseits kann durch Verwendung eines erfindungsgemäßen ausgebildeten Signalpegelwandlers in einer CML/ECL-Schaltstufe diese bei Nichtbedarf abgeschaltet werden, wodurch Strom- bzw. Verlustleistung eingespart werden kann.

## Patentansprüche

1. Signalpegelwandler zur Umsetzung von digitalen Eingangssignalpegeln auf CML- bzw. ECL-Ausgangssignalpegel bei einem geSgenüber einem Ausgangssignalpegelhub größeren Eingangssignalpegelhub unter Verwendung eines Stromquellen-Feldeffekttransistors (Q) zur Bildung einer Konstantstromquelle, die in einem Strompfad zwischen einem Versorgungsspannungspotential (VEE) und einem ersten Anschluß eines Arbeitswiderstandes (R) angeordnet ist, wobei der erste Anschluß des Arbeitswiderstandes (R) als Wandlerausgang (A-CML) für CML dient und/oder an eine Basiselektrode eines als Emitterfolger geschalteten Bipolartransistors angeschlossen ist, dessen Emitterelektrode als Wandlerausgang (A-ECL) für ECL dient, und der Arbeitswiderstand (R) an seinem zweiten Anschluß mit einem für CML bzw. ECL zur Bildung eines digitalen H-Pegels vorgesehenen weiteren Versorgungsspannungspotentials (VCC) verbunden ist, sowie eines im Strompfad zwischen Arbeitswiderstand (R) und Versorgungsspannungspotential (VEE) angeordneten Schaltelementes, das aus wenigstens einem Steuerungs-Feldeffekttransistor (S) mit einer als Wandlereingang (E) dienenden Gate-Elektrode besteht.

2. Signalpegelwandler nach Anspruch 1,
**dadurch gekennzeichnet,** daß der Stromquellen-Feldeffekttransistor (Q) und der Steuerungs-Feldeffekttransistor (S) durch eine Serienschaltung ihrer Drain-Source-Strecken miteinander verbunden sind und daß der Stromquellen-Feldeffekttransistor (Q) an seiner Gateelektrode mit einer Referenzspannung (VBIAS) zur Einstellung eines Konstantstromwertes beaufschlagt ist.

3. Signalpegelwandler nach Anspruch 1 oder 2,
**dadurch gekennzeichnet,** daß zur Erzielung eines schnellen Schaltverhaltens das Schaltelement zwischen Arbeitswiderstand (R) und Konstantstromquelle angeordnet ist.

4. Signalpegelwandler nach einem der vorhergehenden Ansprüche,
**dadurch gekennzeichnet,** daß zur Erzielung eines exakten Spannungswertes für einen digitalen L-Pegel am Wandlerausgang (A) der Stromquellen-Feldeffekttransistor (Q) mit seiner Source-Elektrode vom Schaltelement abgewandt angeschlossen ist.

5. Signalpegelwandler nach einem der vorhergehenden Ansprüche,
**dadurch gekennzeichnet,** daß der Steuerungs-Feldeffekttransistor (S) als N-MOS-Feldeffekttransistor ausgebildet und so dimensioniert ist, daß der Signalpegelwandler als TTL-CML/ECL-Signalwandler verwendbar ist.

6. Signalpegelwandler nach einem der vorhergehenden Ansprüche,
**dadurch gekennzeichnet,** daß zur Bildung von logischen Verknüpfungen das Schaltelement mehrere Steuerungs-Feldeffekttransistoren (S1,S2,S3) aufweist, deren Drain-Source-Strecken zueinander seriell und/oder parallel geschaltet sind und deren Gate-Elektroden logisch verknüpfbare Wandlereingänge (E1,E2,E3) bilden.

7. Signalpegelwandler nach einem der vorhergehenden Ansprüche,
**dadurch gekennzeichnet,** daß der Strompfad über einen Eingangsstromast einer Stromspielgelschaltung an das Versorgungsspannungspotential (VEE) angeschlossen ist und daß die Stromspiegelschaltung wenigstens einen Ausgangsstromast aufweist, der einen weiteren Strompfad vom Versorgungsspannungspotential (VEE) über einen weiteren Arbeitswiderstand (R2) zum weiteren Versorgungsspannungspotential (VCC) bildet, wobei der weitere Arbeitswiderstand (R2) an seinem dem weiteren Versorgungsspannungspotential (VCC) abgewandten Anschluß einen weiteren Wandlerausgang (A2) zur Verfügung stellt.

8. Signalpegelwandler nach Anspruch 7,
**dadurch gekennzeichnet,** daß die Stromspiegelschaltung aus N-MOS-Feldeffekttransistoren gebildet ist.

9. Signalpegelwandler nach einem der Ansprüche 1 bis 6,
**dadurch gekennzeichnet,** durch eine Verwendung als abschaltbare Konstantstromquelle in CML/ECL-Schaltstufen.

10. Signalpegelwandler nach Anspruch 9,
**dadurch gekennzeichnet,** daß bei einem als Stromschalter ausgebildeten Differenzverstärker mit zwei Emitter gekoppelten Bipolartransistoren (DT1,DT2) die Emitterelektroden der Bipolartransistoren über eine Serienschaltung der Drain-Source-Strecken eines als N-MOS-Feldeffekttransistor ausgebildeten Stromquellen-Feldeffekttransistors (Q) und eines Steuerungs-Feldeffekttransistors (S) mit dem Versorgungsspannungspotential (VEE) verbunden sind.
